Europäisches Patentamt

(19) European Patent Office

Office européen des brevets

(11) Publication number : **0 433 992 B1**

## EUROPEAN PATENT SPECIFICATION

(45) Date of publication of patent specification :
16.03.94 Bulletin 94/11

(51) Int. Cl.⁵ : **C04B 41/88**

(21) Application number : **90124603.3**

(22) Date of filing : **18.12.90**

(54) **Method of forming metallized layer on aluminium nitride sintered body.**

(30) Priority : **20.12.89 JP 331726/89**

(43) Date of publication of application :
26.06.91 Bulletin 91/26

(45) Publication of the grant of the patent :
16.03.94 Bulletin 94/11

(84) Designated Contracting States :
**DE FR GB IT**

(56) References cited :
**EP-A- 265 231**
**EP-A- 0 276 788**

(73) Proprietor : **SUMITOMO ELECTRIC INDUSTRIES, LTD.**
**5-33, Kitahama 4-chome, Chuo-ku**
**Osaka-shi, Osaka 541 (JP)**

(72) Inventor : **Yamakawa, Akira, c/o Itami Works of Sumitomo**
**Electric Industries, Ltd., 1-1 Koyakita 1-chome**
**Itami-shi, Hyogo (JP)**
Inventor : **Sasame, Akira, c/o Itami Works of Sumitomo**
**Electric Industries, Ltd., 1-1 Koyakita 1-chome**
**Itami-shi, Hyogo (JP)**

(74) Representative : **Kirschner, Klaus Dieter, Dipl.-Phys. et al**
**Patentanwälte Herrmann-Trentepohl, Kirschner, Grosse, Bockhorni & Partner**
**Forstenrieder Allee 59**
**D-81476 München (DE)**

## Description

The present invention relates to a method of forming a metallized layer containing tungsten as a metal component on a surface of an aluminum nitride sintered body.

In recent years, a semiconductor device has been highly integrated with an increased operating speed, and the degree of integration has been extremely improved particularly in LSI etc. Thus, heat radiation property has been increasingly emphasized as to a substrate material for carrying a semiconductor element thereon.

A ceramic material for such an IC substrate has been generally prepared from alumina ($Al_2O_3$). However, a conventional alumina sintered body has low thermal conductivity and insufficient heat radiation property. Thus, it is difficult to apply such an alumina sintered body to a ceramic material for a substrate, which can sufficiently cope with increase in calorific power of an IC chip.

In place of such an alumina substrate, attention has recently been directed to a substrate or a heat sink which is prepared from alumina nitride having high thermal conductivity, and deep study has been made to put the same into practice.

Aluminum nitride is a material essentially having high thermal conductivity and high insulability, with no toxity dissimilarly to beryllia, which also has high thermal conductivity. Thus, aluminum nitride is expected as an insulating material or a package material for a semiconductor device. However, an aluminum nitride sintered body having the aforementioned characteristics is disadvantageous in junction strength with respect to a metal or vitreous material. Such an aluminum nitride sintered body with a metallized layer on its surface. This metallized layer is formed by a thick film forming method of directly applying commercially available metallizing paste onto the surface of the aluminum nitride sintered body, or a thin film method of forming a thin film of an active metal or a metal by a technique such as vapor deposition. In the metallized layer formed by such a method, however, it is impossible to attain sufficiently practicable junction strength with respect to the aluminum nitride sintered body. In practice, therefore, it is necessary to reform the surface of the aluminum nitride sintered body by some technique before or during the metallization step, in order to improve junction strength with respect to a metal, for example.

In a well-known conventional method for such reforming, an oxide layer is formed by oxidizing a surface of an aluminum nitride sintered body.

For example, Japanese Patent Publication No. 58-11390 (1983) discloses a method of forming an oxide layer of $SiO_2$, $Al_2O_3$, mullite, $Fe_2O_3$ and the like on a surface of an aluminum nitride sintered body. However, although such an oxide layer has excellent affinity with respect to a glass layer, an alumina layer etc., it is inferable that the same has small affinity with respect to the aluminum nitride sintered body itself and is disadvantageous in reliability. The wording "reliability" includes such conditions that junction strength between the oxide layer and the aluminum sintered body involves no dispersion, constant junction strength can be maintained in a prescribed heat cycle test, and the like.

On the other hand, Japanese Laying-Open No. 63-115393 (1988) discloses a method of applying conductive paste which is mainly composed of tungsten and/molybdenum and an agent for reinforcing junction strength prepared from an oxide mixture of $SiO_2$, $AlO_2$ and CaO onto an aluminum nitride sintered body and thereafter firing the same at a temperature of at least 1600°C. However, this method has such problems that the firing temperature is too high and the as-formed metallized layer is rather insufficient in reliability.

Document EP-A-276788 discloses a method of forming a metallized layer on a surface of an aluminum nitride sintered body by coating a metal paste of tungsten of molybdenum on the surface of the sintered body and then firing the sintered body in an inert atmosphere at a temperature of 1500 to 1800°C - The metal paste contains 40 to 98 wt% of tungsten or molybdenum and 2 to 60 wt% of oxide (1 to 25 wt% of $Al_2O_3$ and 1 to 35 wt% of CaO).

Document EP-A-265231 discloses a method of forming a metallized layer on a surface of a ceramic member by applying a metal paste of molybdenum on the surface of the ceramic member and then firing the ceramic member withe the dried metal paste in a wet mixed gas of hydrogen and nitrogen at a temperature of 1200°C to 1400°C - The metal paste contains 50 to 85 wt% of molybdenum and 15 to 50 wt% of component forming a glass phase - These are composed of 5 to 25 wt% of $Al_2O_3$, 35 to 55 wt% of $SiO_2$ and 30 to 55 wt% of MuO.

An object of the present invention is to provide a method of forming a metallized layer on an aluminum nitride sintered body, which can form a metallized layer having high junction strength and high reliability at a lower firing temperature.

The inventive method of forming a metallized layer on a surface of an aluminum nitride sintered body comprises the steps of:

(a) preparing an aluminum sintered body previously fired/formed to have a prescribed configuration;

(b) preparing metal paste of tungsten containing at least 10 percent by weight and not more than 40 percent by weight of oxide components including $SiO_2$, $Al_2O_3$ and CaO, whereby $SiO_2$ is comprised in a content

2

of at least 1 percent by weight and not more than 30 percent by weight, and CaO is present in a weight ratio of at least 0.5 and not more than 2 with respect to $A\ell_2O_3$;

(c) applying the metal paste onto the surface of the aluminum nitride sintered body; and

(d) heating/firing the aluminum nitride sintered body coated with the metal paste in a non-oxidizing atmosphere under a temperature of at least 1500°C and less than 1600°C.

In a conventional method of forming a metallized layer, oxide components for providing sufficient wettability and junction strength between the aluminum nitride sintered body and tungsten have not been sufficiently studied. On the other hand, the present invention defines the optimum range of such oxide components as described above.

According to the inventive method of forming a metallized layer, metal paste having prescribed composition is applied onto a surface of an aluminum nitride sintered body by screen printing or the like, and then fired. The metal paste is mainly composed of oxide components and a metal conductor component of tungsten, and contains an organic substance in addition. This organic substance is formed of ethyl cellulose resin or acrylic resin and a solvent responsive to the resin. The oxide components are important elements in the inventive method of forming a metallized layer. The oxide components include $A\ell_2O_3$, CaO and $SiO_2$. The metal paste contains at least 10 percent by weight and not more than 40 percent by weight of such oxide components. If the content of the oxide components is less than 10 percent by weight, junction strength of the as-formed metallized layer with respect to the aluminum nitride sintered body is reduced, while a plated layer formed on the surface of the metallized layer is significantly blistered or stained in plating. If the content of the oxide components exceeds 40 percent by weight, on the other hand, an oxide layer is formed on a surface of the as-formed metallized layer to cause difficulty in plating, while the plated layer is blistered or stained. The content of the oxide components contained in the metal paste is preferably appropriately selected in a range of at least 10 percent be weight and not more than 30 percent by weight. If the content of the oxide components is within this range, it is possible to obtain a metallized layer which has particularly high junction strength and is excellent in platability.

The oxide components includes $SiO_2$ in a content of at least 1 percent by weight and not more than 30 percent by weight. In such oxide components, a weight ratio ($CaO/A\ell_2O_3$) of CaO with respect to $A\ell_2O_3$ is at least 0.5 and not more than 2. If the content of $SiO_2$ exceeds 30 percent by weight, adhesive strength between the as-formed metallized layer and the aluminum nitride sintered body is reduced. If the content of $SiO_2$ is less than 1 percent by weight, on the other hand, the as-formed metallized layer is deteriorated upon plating of its surface and adhesive strength with respect to the aluminum sintered body is reduced. Further, if the weight ratio of CaO to $A\ell_2O_3$ exceeds 2, adhesive strength of the metallized layer with respect to the aluminum nitride sintered body is reduced. If the weight ratio of Cao to $A\ell_2O_3$ is less than 0.5, on the other hand, a glass component is remarkably raised during heating/firing.

Oxides of elements belonging to the groups I, II, III and IV of the periodic table, such as MgO, $Nd_2O$, $Y_2O_3$, $TiO_2$ and $B_2O_3$, for example, may be added to the metal paste having the aforementioned composition, if necessary. The oxides contained in the metal paste may be previously mixed, heated and vitrificated to be then added to the metal paste. Alternatively, each oxide may be independently kneaded with tungsten. Further, each oxide contained in the metal paste may be mixed with tungsten in the form of a compound such as carbonate. While tungsten is employed as a conductor component for the metal paste in the inventive method of forming a metallized layer, it is preferable to use fine tungsten particles. In particular, a metallized layer having high junction strength can be obtained by using metal powder of fine particles and coarse particles which are mixed to be not more than 1 μm in mean particle size. Further, a transition metal element may be added to the metal paste in an amount of not more than 1 percent by weight, in order to facilitate firing of tungsten.

The components forming the metal paste are sufficiently kneaded with each other by a ball mill, a triple-roll mill or the like. The as-formed metal paste is applied onto a surface of the aluminum nitride sintered body by screen printing, brush application or the like. The aluminum nitride sintered body thus coated with the metal paste in then dried and heated/fired in a non-oxidizing atmosphere at a temperature of at least 1500°C and less than 1600°C. If the firing temperature is less than 1400°C, the sintered body is merely insufficient fired and junction strength of the as-formed metallized layer with respect to the aluminum nitride sintered body is reduced.

The foregoing and other objects, features, aspects and advantages of the present invention will become more apparent from the following detailed description of the present invention when taken in conjunction with the accompanying drawings.

Fig. 1 is a side elevational view showing a method of measuring peel strength of a lead frame which is joined onto an aluminum nitride sintered carrier through a metallized layer;

Fig. 2 is a ternary composition diagram of $SiO_2$, $A\ell O_3$ and CaO, in which peel strength values are plotted in correspondence to compositions of oxide components contained in metal paste materials employed in the present invention;

Fig. 3 is a graph showing relations between contents of oxide components contained in metal paste materials and peel strength values; and

Fig. 4 is a graph showing relations between firing temperatures and peel strength values.

## DESCRIPTION OF THE PREFERRED EMBODIMENTS

### Example 1

Ethyl cellulose and butyl carbitol were added to tungsten powder materials having particle size distributions shown in Table 1 and oxide components, and sufficiently kneaded by a triple-roll mill, to prepare samples of metal paste. As to the particle size distributions shown in Table 1, the expression "0.5/1.0 = 1" of sample No. 1, for example, indicates that tungsten particles of 0.5μm and 1.0μm in mean particle size mixed in a weight ratio of 1:1. Further, "0.5 only" for sample No. 14, for example, indicates that the tungsten powder was prepared from only particles of 0.5μm in mean particle size. As to the sample No. 19, nickel powder was added to the tungsten powder in a mixing ratio 0.5:99.5 of nickel to tungsten in weight percentage. As to the sample No. 20, the molybdenum powder was added to the tungsten powder in a mixing ratio of 10:90 of molybdenum to tungsten in weight percentage.

The tungsten paste materials were applied to sintered carriers of aluminum nitride containing 99 percent by weight of $A\ell n$ by screen printing, to form pads of 2mm by 2mm in application area. The samples were then heated/fired in accordance with firing conditions shown in Table 1. Referring to Table 1, "$N_2$-5$H_2$" indicates that $N_2$ gas and $H_2$ gas were mixed in a volume ratio of 95:5.

Nickel-plated layers of 1.0μm in thickness were formed on surfaces of the as-formed metallized layers. Lead frames of 2mm in width and 0.1 mm in thickness were silver-brazed on the nickel-plated layers. The lead frames were pulled in prescribed directions, in order to measure peel strength values.

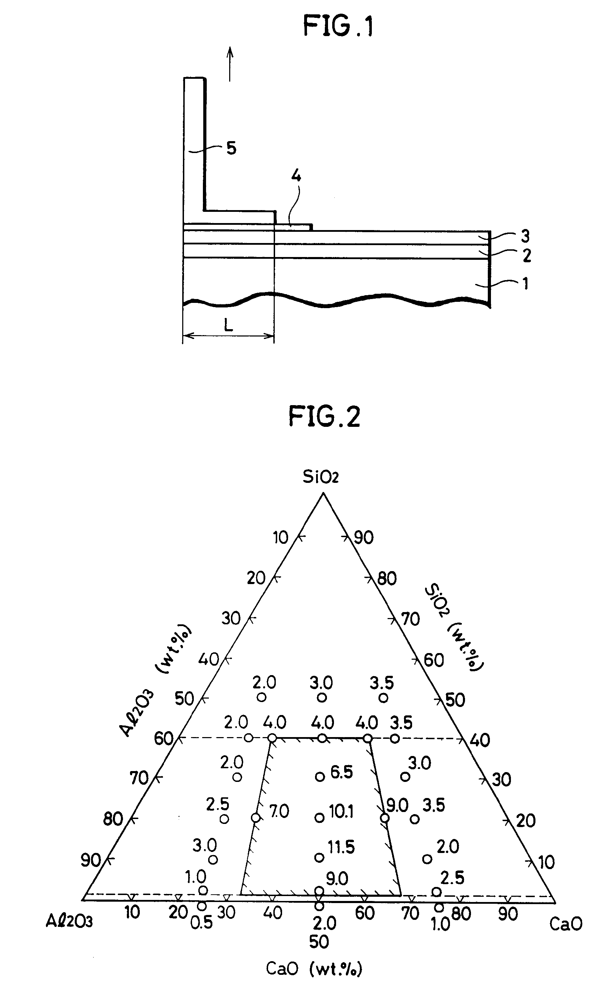

Fig. 1 shows a method of measuring peel strength. A metallized layer 2 is formed on an aluminum nitride sintered carrier 1. A nickel-plated layer 3 is formed on the metallized layer 2. A lead frame 5 is joined onto the nickel-plated layer 3 through a silver solder member 4. Referring to Fig. 1, symbol L denotes a length of 1.7 mm. The lead frame 5 is pulled at a rate of 20mm/min. along an arrow, in order to measure peel strength.

Table 1 also shows the peel strength values measured in the aforementioned manner. The samples shown with marks * are reference examples. As understood from Table 1, the metallized layers formed according to the inventive method are excellent in junction strength, with peel strength values of at least 4 kg.

4

Table 1

| Sample No. | Particle Size Distribution of Tungsten | Oxide Components (wt. %) | | | | | Firing Conditions | | | peel strength (kg) |
|---|---|---|---|---|---|---|---|---|---|---|
| | | Total | Al$_2$O$_3$ | CaO | SiO$_2$ | Others | gas | temperature (°C) | Time (min.) | |
| *1 | 0.5/1.0 = 1 | 0.5 | 40 | 40 | 20 | | N$_2$-5H$_2$ | 1550 | 60 | 2 |
| *2 | do. | 1.5 | do. | do. | do. | | do. | do. | do. | 5 |
| 3 | do. | 10 | do. | do. | do. | | do. | do. | do. | 9 |
| 4 | do. | 20 | do. | do. | do. | | do. | do. | do. | 12 |
| 5 | do. | 35 | do. | do. | do. | | do. | do. | do. | 8 |
| *6 | do. | 45 | do. | do. | do. | | do. | do. | do. | 4 |
| *7 | do. | 10 | do. | do. | do. | | do. | 1350 | do. | 2 |
| *8 | do. | do. | do. | do. | do. | | do. | 1450 | do. | 5 |
| *9 | do. | do. | do. | do. | do. | | do. | 1700 | do. | 6 |
| *10 | do. | do. | do. | do. | do. | | do. | 1900 | do. | 5 |
| 11 | do. | do. | do. | do. | do. | | H$_2$ | 1550 | do. | 9 |
| 12 | do. | do. | do. | do. | do. | | N$_2$ | do. | do. | 10 |
| 13 | 1.0/3.0 = 1 | do. | do. | do. | do. | | do. | do. | do. | 7 |
| 14 | 0.5 only | do. | do. | do. | do. | | do. | do. | do. | 6 |
| 15 | 3.0 only | do. | do. | do. | do. | | do. | do. | do. | 4 |
| 16 | 0.5/1.0 = 1 | 20 | do. | do. | 19 | B$_2$O$_3$:1 | do. | do. | do. | 9 |
| 17 | do. | do. | do. | do. | 19 | MgO:1 | do. | do. | do. | 10 |
| 18 | do. | do. | do. | do. | 15 | Y$_2$O$_3$:5 | do. | do. | do. | 11 |
| 19 | do. | do. | do. | do. | do. | | do. | do. | do. | 10 |
| 20 | do. | do. | do. | do. | do. | | do. | do. | do. | 8 |

Example 2

Al$_2$O$_3$, CaO and SiO$_2$ were mixed in various compounding ratios and kneaded with tungsten powder materials having prescribed particle size distributions, to contain 15 percent by weight of oxide components. The tungsten powder materials were so prepared as to contain particles of 0.4μm and 1.5μm in mean particle size in a weight ratio of 1:1 respectively. Metallized layers were formed on surfaces of aluminum nitride sintered bodies by the as-formed tungsten paste materials, similarly to Example 1. These samples were fired in a nitrogen gas atmosphere at a temperature of 1550°C.

Lead frames were joined onto the respective samples similarly to Example 1, in order to measure peel strength values. Fig. 2 shows the results of the measured peel strength values, in correspondence to compounding ratios of the oxide components contained in the respective samples of metal paste materials. Fig. 2 is a ternary composition diagram (wt. %) of $SiO_2$, $Al_2O_3$ and CaO. The peel strength values of the respective samples are plotted in numerical values (kg). Referring to Fig. 2, hatched lines enclose a range of compositions of the oxide components according to the present invention. As understood from Fig. 2, the metallized layers formed by the metal paste materials having oxide components according to the present invention exhibit junction strength values of at least 4.0 kg as peel strength values.

## Example 3

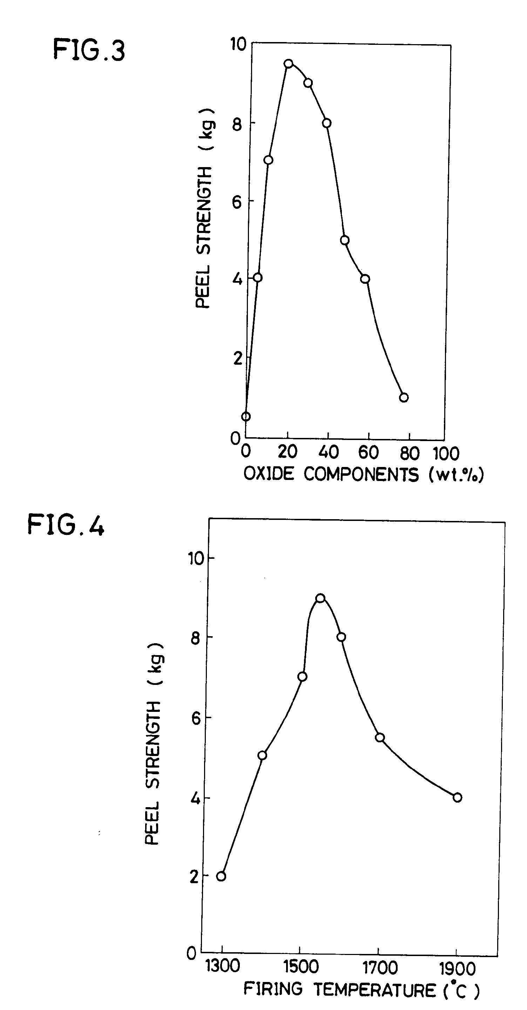

Tungsten particles of 0.5μm and 1.0μm in mean particle size were mixed in a weight ratio of 1:1, to prepare tungsten powder for metal paste. $Al_2O_3$ powder, CaO powder and $SiO_2$ powder of 0.5μm in mean particle size were blended in weight ratios of 45:45:10 and sufficiently mixed to prepare oxide component powder. The tungsten powder and the oxide component powder were mixed with each other in various ratios, while ethyl cellulose and butyl carbitol were added to the mixtures and sufficiently kneaded, to prepare samples of metal paste materials. The as-formed tungsten paste materials were applied to sintered carriers (180 W/mK in thermal conductivity) aluminum nitride containing at least 99 percent by weight of $AlN$ by screen printing, similarly to Example 1. Thereafter the samples were heated/fired in $N_2$ gas at a temperature of 1530°C for one hour. In order to evaluate the as-formed metallized layers, peel strength values were measured similarly to Example 1. Fig. 3 shows the results of the measured peel strength values. As clearly understood from Fig. 3, junction strength of such a metallized layer is further improved when the content of the oxide components is in a range of 10 to 30 percent by weight.

## Example 4

The tungsten paste materials containing 10 percent by weight of oxide components prepared in Example 3 were applied to aluminum nitride sintered carriers by screen printing, similarly to Example 1. Thereafter the samples were heated/fired in $N_2$-50% $H_2$, at various temperatures. In order to evaluate the as-formed metallized layers, peel strength values were measured similarly to Example 1. Fig. 4 shows the results of the measured peel strength values. As clearly understood from Fig. 4, junction strength of such a metallized layer is further improved when the firing temperature is in a range of 1500 to 1600°C.

## Example 5

10 percent by weight of the oxide component powder materials having prescribed compounding ratios, which were prepared in Example 3, were sufficiently kneaded with tungsten powder materials having particle size distributions shown in Table 2 similarly to Example 1, to prepare samples of metal paste materials. The as-formed tungsten paste materials were applied to aluminum nitride sintered carriers similarly to Example 3, and thereafter heated/fired at a temperature of 1550°C. In order to evaluate the as-formed metallized layers, peel strength values were measured similarly to Example 1. Table 2 also shows the results of the measured peel strength values.

Table 2

| Sample No. | Particle Size Distribution of Tungsten | Mean Particle Size ($\mu$m) | Peel Strength (kg) |
|---|---|---|---|
| 51 | 0.5/1.0 = 2/1 | 0.67 | 9 |
| 52 | 0.5/1.0 = 1/1 | 0.75 | 10 |
| 53 | 0.5/1.5 = 1/1 | 1.0 | 8 |
| 54 | 0.5/2.0 = 1/1 | 1.3 | 6 |
| 55 | 0.5 only | – | 5 |
| 56 | 2.0 only | – | 4 |

Referring to Table 2, the particle size distributions of tungsten are expressed similarly to Table 1.

As clearly understood from Table 2, a metallized layer having higher junction strength can be obtained when the tungsten powder is not more than 1 $\mu$m in mean particle size.

**Claims**

1.  A method of forming a metallized layer on a surface of an aluminum nitride sintered body, comprising the steps of:
    preparing an aluminum nitride sintered body previously fired/formed to have a prescribed configuration;
    preparing metal paste of tungsten containing at least 10 percent by weight and not more than 40 percent by weight of oxide components, including $SiO_2$, $Al_2O_3$ and CaO, whereby $SiO_2$ is comprised in a content of at least 1 percent by weight and not more than 30 percent by weight and CaO is present in a weight ratio of at least 0.5 and not more than 2 with respect to $Al_2O_3$;
    applying said metal paste onto a surface of said aluminum nitride sintered body; and
    heating/firing said aluminum nitride sintered body coated with said metal paste in a non-oxidizing atmosphere at a temperature of at least 1500°C and less than 1600°C.

2.  A method of forming a metallized layer in accordance with claim 1, wherein said metal paste contains at least 10 percent by weight and not more than 30 percent by weight of said oxide components.

3.  A method of forming a metallized layer in accordance with claim 1, wherein said step of preparing said metal paste of tungsten includes a step of kneading tungsten powder with said oxide components.

4.  A method of forming a metallized layer in accordance with claim 3, wherein said tungsten powder contains fine and coarse particles which are mixed to be not more than 1$\mu$m in mean particle size.

**Patentansprüche**

1.  Verfahren zu Herstellung einer metallisierten Schicht auf einer Oberfläche eines Aluminiumnitrid-Sinterkörpers **gekennzeichnet durch:**

7

EP 0 433 992 B1

Herstellung eines in einer vorgeschriebenen Formgebung vorher gebrannten/ausgebildeten Aluminiumnitrid-Sinterkörpers,

Herstellung einer Wolfram-Metallmasse mit mindestens 10 Gew.-% und nicht mehr als 40 Gew.-% an Oxidbestandteilen einschließlich SiO$_2$, Al$_2$O$_3$ und CaO, wobei SiO$_2$ mit einem Anteil von mindestents 1 Gew.-% und nicht mehr als 30 Gew.-% und CaO mit einem Gewichtsverhältnis zu Al2O$_3$ von mindestens von 0,5 und nicht mehr als 2 enthalten ist,

Aufbringen der Metallmasse auf eine Oberfläche des Aluminiumnitrid-Sinterkörpers und

Aufheizen/Brennen des mit der Metallmasse beschichteten Aluminumnitrid-Sinterkörpers in einer nicht oxidierenden Atmosphäre bei einer Temperatur von mindestens 1500° C und weniger als 1600° C.

2.  Verfahren zur Herstellung einer metalisierten Schicht nach Anspruch 1 **dadurch gekennzeichnet,** daß die Metallmaße mindestens 10 Gew.-% und nicht mehr als 30 Gew.-% der Oxidbestandteile enthält.

3.  Verfahren zur Herstellung einer metallisierten Schicht nach Anspruch 1 **dadurch gekennzeichnet,** daß die Herstellung der Wolfram-Metallmasse die Verknetung des Wolframpulvers mit den Oxidbestandteilen beinhaltet.

4.  Verfahren zur Herstellung einer metallisierten Schicht nach Anspruch 3, **dadurch gekennzeichnet,** daß das Wolframpulver feine und grobe Teilchen enthält, die zur Gewinnung einer mittleren Teilchengröße von nicht mehr als 1 μ vermischt werden.

**Revendications**

1.  Procédé de formation d'une couche métallisée sur une surface d'un corps fritté de nitrure d'aluminium, comprenant les étapes :

    de préparation d'un corps fritté de nitrure d'aluminium auparavant cuit/formé pour avoir une configuration prescrite;

    de préparation d'une pâte de métal de tungstène contenant au moins 10 pour cent en poids et pas plus de 40 pour cent en poids de composants oxydés, incluant SiO$_2$, Al$_2$O$_3$ et CaO, où SiO$_2$ est contenu en une teneur d'au moins 1 pour cent en poids et de pas plus de 30 pour cent en poids, CaO est présent en un rapport pondéral d'au moins 0,5 et de pas plus de 2 par rapport à Al$_2$O$_3$ ;

    d'application de ladite pâte de métal sur une surface dudit corps fritté de nitrure d'aluminium ; et

    de chauffage/cuisson dudit corps fritté de nitrure d'aluminium revêtu de ladite pâte de métal, dans une atmosphère non oxydante, à une température d'au moins 1500 °C et inférieure à 1600 °C.

2.  Procédé de formation d'une couche métallisée selon la revendication 1, dans lequel ladite pâte de métal contient au moins 10 pour cent en poids et pas plus de 30 pour cent en poids desdits composants oxydés.

3.  Procédé de formation d'une couche métallisée selon la revendication 1, dans lequel ladite étape de préparation de ladite pâte de métal de tungstène inclut une étape de malaxage de poudre de tungstène avec lesdits composants oxydés.

4.  Procédé de formation d'une couche métallisée selon la revendication 3, dans lequel ladite poudre de tungstène contient des particules fines et grossières qu'on mélange afin qu'elles ne soient pas de plus de 1 μm de taille moyenne.

# FIG.1

# FIG.2

FIG.3

FIG.4